Europäisches Patentamt

European Patent Office

Office européen des brevets

(19)

(11) Publication number: 0 164 186
A1

## EUROPEAN PATENT APPLICATION

(21) Application number: 85302276.2

(22) Date of filing: 01.04.85

(51) Int. Cl.⁴: H 01 L 21/28

(30) Priority: 02.04.84 US 595796

(71) Applicant: Monolithic Memories, Inc., 2175 Mission College Blvd., Santa Clara, CA 95050 (US)

(72) Inventor: Hsia, Steve, 19651 La Mar Court, Cupertino California 95014 (US)
Inventor: Chang, Paul, 1420 Cedar Place, Los Altos California 94022 (US)

(43) Date of publication of application: 11.12.85
Bulletin 85/50

(74) Representative: Ackroyd, Robert et al, POLLAK MERCER & TENCH High Holborn House 52-54 High Holborn, London WC1V 6RY (GB)

(84) Designated Contracting States: DE FR GB NL

(54) Method of manufacturing CMOS devices.

(57) A method of forming an insulation sidewall spacer in a semiconductor structure which has a layer of polycrystalline silicon (23) overlain by a layer (121) of material which etches more slowly than polycrystalline silicon for a selected etchant.

Etching the semiconductor structure causes a portion of the second layer to overhang a portion of the first layer. By conformally depositing a layer of insulation on the etched semiconductor structure and then vertically etching the resulting structure, insulation sidewall spacers (71) are formed which fill the region under the overhanging portion of the second layer thus reducing the capacitance between the overhanging portion of the second layer and other portions of the semiconductor structure.

# METHOD OF MANUFACTURING CMOS DEVICES

Steve Hsia
Paul Chang

## BACKGROUND OF THE INVENTION

This invention relates to a method for forming an insulation sidewall spacer in a semiconductor structure, and in particular to a method for forming an insulation sidewall spacer in a semiconductor structure that has at least two layers of different semiconductor material.

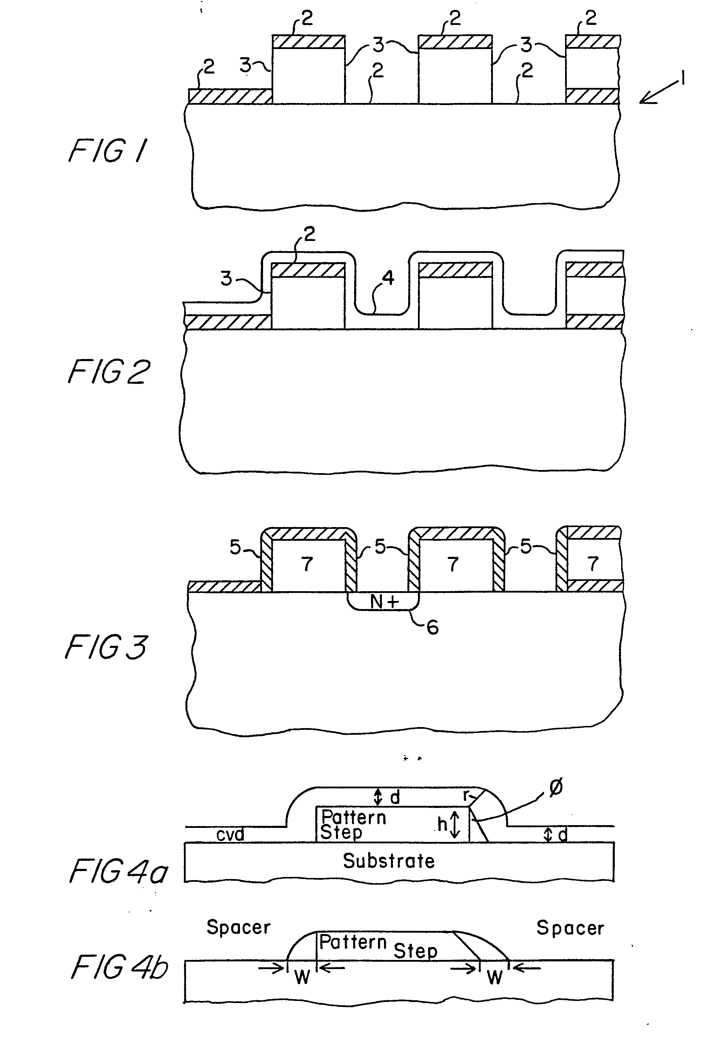

One prior art method of forming insulation sidewall spacers (defined below) is described in U.S. Patent No. 4,234,362 issued to Riseman on November 18, 1980 which is incorporated herein by reference. In the Riseman method first a semiconductor structure 1 is formed having "substantially horizontal surfaces" 2 and "substantially vertical surfaces" 3 as shown in Fig. 1. A conformal insulation layer 4 is then formed on the semiconductor structure of Fig. 1 as shown in Fig. 2. Insulation layer 4 may be one of several insulating materials such as silicon dioxide, silicon nitride, aluminum oxide, or combinations of these materials. Riseman states that the structure shown in Fig. 2 is then placed in a reactive ion etching ambient where the insulation layer 4 is substantially removed from the horizontal surfaces 2 without significantly affecting the insulation layer on the vertical regions 3 in order to produce the vertical insulation regions called the insulation sidewall spacers 5 shown in Fig. 3. These insulation sidewall spacers 5 provide electrical separation between conductive regions in the semiconductor structure, for example between $N^+$ emitter region 6 and polycrystalline silicon regions 7 shown in Fig. 3. Riseman further states that the desired thickness of insulation sidewall spacers 5 is the thickness of the conformal insulation layer 4 on the horizontal surfaces 2 of semiconductor structure 1. The thickness of the conformal layer is chosen for device design purposes such as emitter-base separation, and depends on the particular insulator used. Riseman suggests a conformal insulator layer having a thickness between 500 Angstroms and 20,000 Angstroms. A thickness of less than 500 Angstroms may lead to an electrical short circuit between conductive regions.

Later work by Riseman and others shows that the relationship between the thickness of the conformal layer and the thickness (width) of the sidewall spacer is more complex than is stated in the '362 patent. In Abstract No. 233, Sidewall Spacer Technology, P.J. Tsang, J.F. Shepard, and J. Riseman, IBM Corporation, Hopewell Junction, N.Y., which is incorporated herein by reference, the authors determined that there are three major factors that affect the final dimension and geometric configuration of an insulation sidewall spacer:

i)   the Chemical Vapor Deposition (CVD) film step coverage, Fsc;

ii)  the etching directionality and etch uniformity of the reactive-ion-etching (RIE) system (the system includes apparatus and etchant gas) used, Fe; and

iii) a geometric factor, which is related to the surface topography of the sample before and after CVD coating, Fg.

Sidewall Spacer Technology concentrates on the geometric factor, Fg, since the first two factors, Fsc and Fe, are inherent properties of the deposition and etching reactors and are fixed. Figs. 4a and 4b illustrate the parameters considered by the authors in formulating their geometric model under the assumptions that:

    i)    the CVD is conformal, i.e., the deposited film assumes the shape of the underlying structure;

   ii)   the CVD deposition resulted in a rounding of the upper corner of the step with the radius (r) of the curvature being equal to the film thickness (d), and centered at the upper corner of the step (as shown in Fig. 4a) and,

 iii)   the RIE is anisotropic.

As shown in Fig. 4a, $\phi$ is the angle that the edge of the pattern step makes with the vertical, d is the thickness of the CVD coating, and h is the height of the step. Fig. 4b depicts the width of the spacer formed when the structure of Fig. 4a is subjected to an anisotropic RIE. The width of the spacer is given by the formula

$$W = F_{sc} \times F_e \times F_g \times d.$$

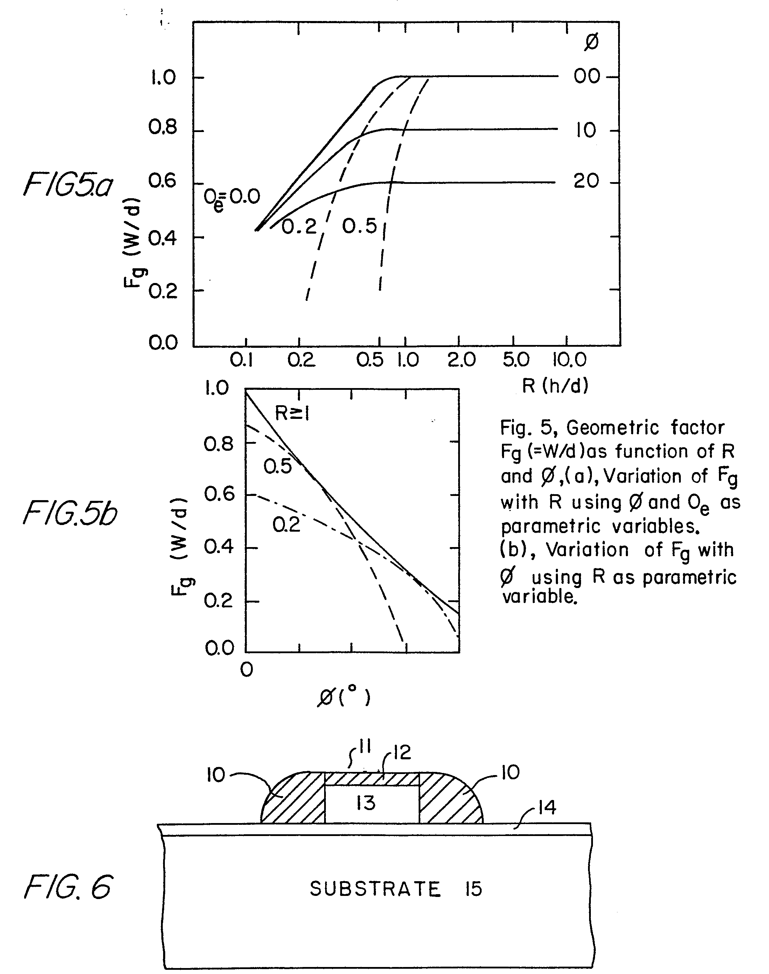

The results reported in Sidewall Spacer Technology are reproduced in Fig. 5a and 5b. An examination of Figs. 5a and 5b show that unless the aspect ratio $R = h/d$ is kept larger than 1.0 and angle $\phi$ equals zero (i.e. a vertical step) the width w of the sidewall produced will always be smaller than the deposited film thickness, i.e., $(w/d) < 1$. In addition, the variation of the width w caused by uncertainty of R, $\emptyset$, and overetch Oe will be larger if $R \leq 1.0$ and $\phi \geq 0$. It is suggested in Sidewall Spacer Technology that for most device applications a sidewall spacer having a width w that is as close as possible to the thickness d of the CVD layer is desired. For these purposes a vertical step and an aspect ratio of 1.5 is recommended, so that the width of the spacer is not sensitive to overetch, as shown in Fig. 5a.

Vertical walled polycrystalline silicon gates for MOS devices can be provided with a sidewall oxide spacer or with a multiple sidewall oxide spacer as shown in

*New* *Edge-Defined* *Vertical-Etch* *Approaches* *For* *Submicro* *meter* *MOSFET* *Fabrication*, W. R. Hunter, T. C. Holloway, P. K. Chatterjee, and A. F. Tosch, Jr., *IEEE-IEDM Tech. Dig.*, *pp. 764-67* *(1980)*, which is incorporated herein by reference.

In *Fabrication* *of* *High-Performance* *LDDFETS* *With* *Oxide* *Sidewall-Spacer* *Technology*, Paul J. Tsang, Seiki Ogura, William W. Walker, Joseph F. Shepard, and Dale L. Critchlow, *IEEE*, *Electron* *Devices*, *ED-29*, *pp. 590-96*, *April 1982*, which is incorporated herein by reference, a process is described wherein oxide sidewall spacers 10 are formed at each end of a dual layer gate stack as shown in Fig. 6. The dual layer gate stack 11 consists of a layer of CVD silicon oxide 12 deposited on a layer of polycrystalline silion 13. Gate oxide layer 14 lies between the gate stack 11 and the substrate 15. Reactive ion etching (RIE) is used to etch both the oxide 12 and the polycrystalline silicon 13 so that vertical sides of the silicon dioxide/polycrystalline silicon gate stack are obtained before the oxide sidewall spacers are formed.

Of importance, in all of the prior art techniques for forming an insulating sidewall spacer, it is recommended or assumed that the spacer be formed abutting a vertical step or a dual layer gate stack having vertical sides. However, vertical sides are difficult to achieve when the gate stack is formed from a dual layer of materials with different etch rates.

For example, in fabricating a MOS device it is difficult to etch a dual layer structure containing a layer of polycrystalline silicon overlain by a layer of silicide (a binary compound of silicon usually with a more electropositive element or radical, such as tungsten) to produce a dual layer gate stack with a vertical wall. Clorine plasma etchants produce a stack with an approxi-

mately vertical wall, but their use is not convenient due to the formation of metal chloride deposits on the exposed metal of the processing equipment and due to their reaction with metals on the wafer being processed. On the other hand an etchant such as $CF_4$ plasma does not have the problem of creating undesirable deposits on the exposed metal of the processing equipment, but its use does not produce a stack with a vertical wall because $CF_4$ plasma etches many metal-silicides at a slower rate than the underlying polycrystalline silicon, thus producing undercutting of the silicide.

Use of a reactive-ion-etch as suggested by Sidewall Spacer Technology, supra, produces a stack with a vertical wall, but this requires more expensive processing equipment than a standard plasma etch and also consumes energy approximately an order of magnitude greater than that consumed by a standard plasma etch.

SUMMARY

The prior art previously described recommends that insulation sidewall spacers be formed abutting a vertical step or vertical stack. In contrast to the prior art, the process for forming an insulation sidewall spacer in accordance with this invention takes advantage of the overhang created by etching a dual layer stack by etchants that have different etch rates on the materials in the dual stack. The method disclosed herein forms an insulation sidewall spacer in a dual layer semiconductor structure which contains a first polycrystalline silicon layer which is overlain by a second layer which has the property that its etch rate is less than the etch rate of the underlying polycrystalline silicon layer for a selected etchant. Typically this second layer is an insulating material, a silicide, or a refractory metal. The insulation sidewall spacer is formed by first removing a portion of the second layer and a portion of the the first polycrystalline silicon layer so that the remaining portion of the second layer overhangs the remaining portion of the first polycrystalline silicon layer.

An insulating layer is then conformally deposited on the resulting structure, and the insulation sidewall spacer is then formed by vertically etching the structure resulting from the conformal deposition of the insulating layer.

The above method of forming insulation sidewall spacers has several advantages as compared with prior art methods, including the fact that stacks having vertical walls need no longer be produced prior to forming the insulation sidewall spacers and the fact that the width of the sidewall is easier to control. These and other advantages are described more fully in the Description of the invention which follows.

BRIEF DESCRIPTION OF THE DRAWINGS

Fig. 1 shows a prior art semiconductor structure having horizontal and vertical sufaces.

Fig. 2 shows a conformal insulation layer deposited on the structure of Fig. 1.

Fig. 3 shows a prior art insulation sidewall spacer.

Fig. 4a shows the geometric quantities that determine sidewall spacer width using prior art techniques.

Fig. 4b shows prior art sidewall spacers.

Fig. 5a shows the geometric factor as a function of aspect ratio using the angle between the step edge and the vertical and overetch as parametric variables.

Fig. 5b shows the geometric factor as a function of the angle between the step edge and the vertical using the aspect ratio as a parametric variable.

Fig. 6 shows a dual layer gate stack for use in a semiconductor device.

Fig. 7 shows a semiconductor structure having a dual layer stack formed by a vertical etch.

Fig. 8 shows the semiconductor structure of Fig. 7 after a plasma etch or a wet etch.

Fig. 9a shows a semiconductor structure including $N^-$ source and drain regions and P type substrate used for forming a P channel device.

Fig. 9b shows a semiconductor structure having $N^-$ source and drain regions and an N type substrate used for forming an N channel device.

Fig. 10 shows a semiconductor structure according to Fig. 9a or Fig. 9b after annealing and conformal deposition of an insulation layer.

Fig. 11 shows the insulation sidewall spacers formed by vertically etching the semiconductor structure of Fig. 10.

Fig. 12a shows the structure of Fig. 11 after an $N^+$ implant where the substrate of Fig. 11 has been doped with a P type dopant.

Fig. 12b shows the structure of Fig. 11 after an $N^+$ implant where the substrate of Fig. 11 has been doped with an N type dopant.

Fig. 13a shows the semiconductor structure of Fig. 12a after annealing.

Fig. 13b shows the semiconductor structure of Fig. 12b after annealing.

Fig. 14a shows the semiconductor structure of Fig. 13a (where the second layer of the gate stack was silicon nitride) after the removal of silicon nitride, deposition of platinum and sintering and removal of unreacted platinum.

Fig. 14b shows the semiconductor structure of Fig. 13b (where the second layer was silicon nitride) after removal of silicon nitride, deposition of platinum and sintering and removal of unreacted platinum.

Fig. 15a shows the semiconductor structure of Fig. 13a (where the second layer was silicide) after the deposition of platinum and the sinter and removal of unreacted platinum. Fig. 15b shows the semiconductor structure of Fig. 13b (where the second layer was silicide) after the deposition of platinum and the sintering and removal of unreacted platinum.

Fig. 16a shows a semiconductor structure containing prior art sidewall spacers.

Fib. 16b show a semiconductor structure having sidewall spacers formed according to Applicant's invention.

DETAILED DESCRIPTION

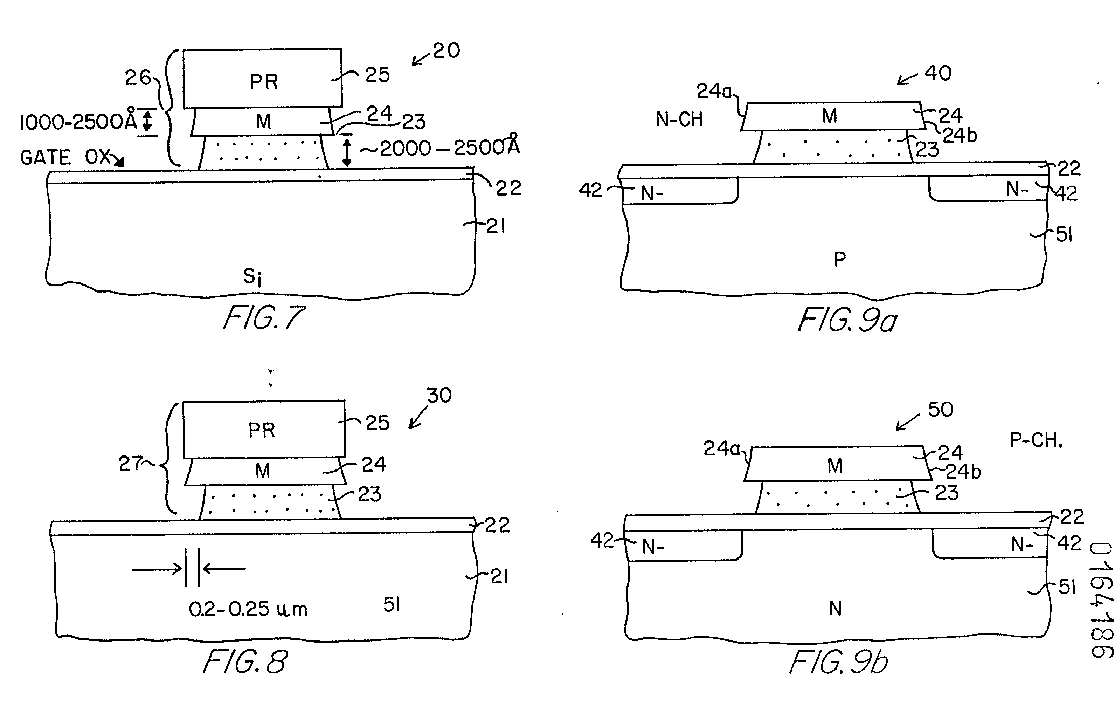

Figs. 7 through 10 show one method of forming insulation sidewall spacers according to the teachings of this invention.

Fig. 7 shows a semiconductor structure including a silicon substrate 21 which is typically doped with either N type impurities or P type impurities. Substrate 21 is covered by a gate insulating layer 22 (typically silicon oxide or silicon nitride). In one embodiment, insulating layer 22 is a layer of silicon oxide grown at 950°C in dry oxygen to a thickness of approximately 450Å . In another embodiment the gate insulating layer of silicon oxide or silicon nitride is formed by well known chemical vapor deposition (CVD). This insulating layer may be alternatively one or a combination of known insulating materials such as oxynitride or the like.

A first layer of polycrystalline silicon 23 is then deposited on the gate oxide layer 22 by low pressure (LP) CVD. Typically polycrystalline silicon 23 is doped, for example with phosphorous or other impurity, in order to increase its conductivity. Typically this doped polycrystalline silicon layer has a thickness between 2000 and 2500 Angstroms (Å).

Second layer 24 of tungsten silicide ($WSi_2$) is deposited on doped polycrystalline silicon layer 23 in a cold wall low pressure CVD reactor. Deposition is done with silane and tungsten hexafluoride diluted with helium at approximately 400°C. Details of this process are described in Properties of Low Pressure CVD Tungsten Silicide as Related to IC Process Requirements, Brors, et al., Solid State Technology, pp. 183-86, April 1983, which is incorporated herein by reference. Layer 24 typically has a thickness between 1000 and 2500Å and is typically an insulating material, a silicide (such as tungsten silicide), or a refractory metal such as tungsten. Second layer 24 may be any material which has a lower etch rate than the underlying doped polycrystalline silicon for a selected etchant.

A layer of photoresist 25 is formed on second layer 24 and patterned by conventional techniques and the resulting structure is anisotropically etched to form structure 20 including multilayer stack 26 as shown in Fig. 7. The anisotropic etch is performed, for example, using plasma $SF_6$.

Structure 20 is then subjected to a plasma etch using $CF_4$ or $SF_6$ or a wet etch using $HF:HNO_3:H_2O=1:60:60$ in order to produce stack 27 shown in Fig. 8. In Fig. 8, second layer 24 is undercut by approximately 2000 to 2,500Å by the plasma etch or wet etch which etches second layer 24 at a slower rate than doped polycrystalline silicon layer 23.

Plasma etchant $CF_4$ or $SF_6$ etches doped polycrystalline silicon layer 23 at a rate approximately twice as fast as second layer 24 when the second layer is tungsten silicide ($WSi_2$).

The process steps described in Figs. 7 and 8 can, if desired, be combined in a single step plasma etch. In one embodiment of this invention dual stack 27 is produced using a single step planar plasma etching system using $SF_6$ as the main etching species.

Whether stack 27 is formed in one or two etching steps, the amount of undercut is easily controlled due to the known differential etch rates of the selected etchant on second layer 24 and on polycrystalline silicon layer 23. In one embodiment an overhang of approximately $1,200\overset{\circ}{A}$ of tungsten silicide by a single step planar plasma etching system using $SF_6$ for approximately 1 minute. The etching characteristics of a dual layer consisting of silicide/polycrystalline-silicon is described in In Line Plasma Etch of Polysilicon and Molybdenum Silicide using $SF_6$, P. Chang, et al., Kodak Microelectronics Seminar Proceedings, pp. 9-14, October 1980, which is incorporated herein by reference.

In one embodiment of this invention, stack 27 is used to form the gate of an insulated gate field effect transistor (IGFET). The gate stack shown in cross-section is one of many such gate stacks formed in a monolithic block of semiconductor material called a chip. In this embodiment photoresist layer 25 is stripped away using conventional techniques and a low dose (typically $1 \times 10^{13}$ ions/$cm^2$) of phosphorus ion is blanket implanted to form $N^-$ source and drain regions 42 as shown in Figs. 9a and 9b. $N^-$ source and drain regions 42 are self aligned with the edges 24a and 24b of second layer 24. In those regions of the chip where silicon substrate 21 is doped with a P type dopant (shown as region 41 in Fig. 9a), semiconductor structure 40 is used to construct an N channel device. In those regions of the chip where silicon substrate 21 is doped with a P type dopant (shown as region 51 in Fig. 9b) semiconductor structure 50 is used to construct a P channel device. It is one of the features of one embodiment of the invention that the low dose phosphorus ion implant is a blanket implant of the entire chip, which eliminates a traditional masking step. Traditionally a masking layer would be formed over the to-be-formed source/drain regions of N channel transistors during the implantation of low dose phosphorous ions in the source/drain regions of to-be-formed P channel transistors.

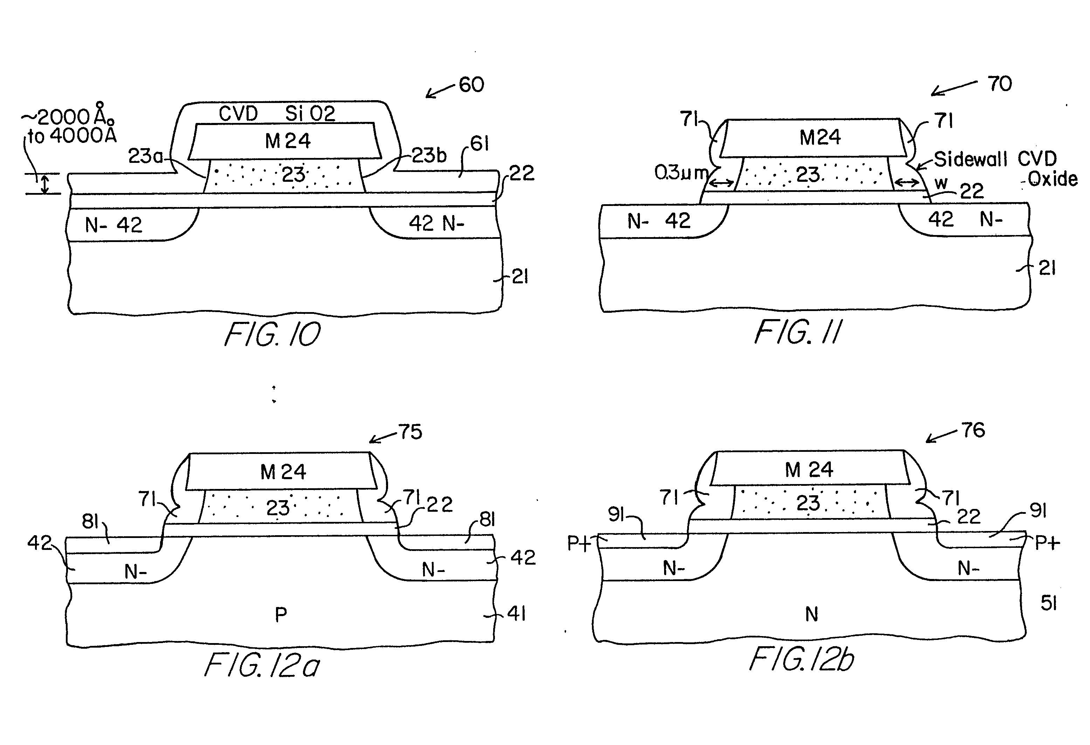

The phosphorus ion implant is followed by a high temperature (950°C to 1000°C) nitrogen annealing cycle to deepen the N- drain and source regions 42 to approximately 0.35 microns and to laterally diffuse these regions part way into the channel between them so that the edges of these regions are aligned with the edges 23a and 23b of polycrystalline silicon layer 23 as shown in Fig. 10. The dopant concentration in region 42 is then approximately $5 \times 10^{17}$ atoms/cm$^3$. The high temperature annealing cycle also reduces the sheet resistivity of the gate interconnection which comprises polycrystalline silicon layer 23 and silicide layer 24. For example, the sheet resistivity is approximately 2 to 3 ohms/square after 25 minutes of annealing, as compared with approximately 30 ohms/square before annealing. Low resistivity of the gate interconnection is required for the formation of high speed semiconductor devices whose channel width is of the order of 2 microns.

Following the annealing step, a conformal layer 61 of SiO$_2$ approximately 2000Å-4000Å thick is formed on semiconductor structure 40 or semiconductor structure 50, for example, by chemical vapor deposition, to produce semiconductor structure 60 shown in Fig. 10. In other embodiments conformal layer 24 is silicon nitride, aluminum oxide, or other insulating material, or combinations of the above.

Next, the structure 60 is vertically etched to remove portions of oxide layers 61 and 22 to expose the doped silicon substrate regions 42 and to form structure 70 having vertical sidewall oxide spacers 71 which fill the regions under the ends of second layer 24 as shown in Fig. 11. The width W of the sidewall oxide spacer 71 as measured near the base of the spacer as shown in Fig. 11 is approximately 0.3 microns. In general the width of an insulation sidewall spacer formed in accordance with the teachings of this invention depends on the thickness of the conformal insulation layer, the differential etch rates of the second layer 24 and the underlying polycrystalline silicon layer 23, the etch time, and the over-etch time. Spacers having a width in the range of about 0.15 $\mu m$ to 0.4 $\mu m$ are produced by controlling these variables. The etchant used in one embodiment is $CHF_3:O_2$ which has a high selectivity for etching insulating layer 22 as compared with silicon. For example, when insulating layer 22 is $SiO_2$ the ratio of the etch rates of layer 22 to silicon is about 5:1 and when insulating layer 22 is silicon nitride, the ratio of the etch rates of layer 22 to silicon is about 2.5:1.

For the formation of N channel devices (i.e. where the underlying substrate region 41 is silicon doped with P type impurities), the vertical etching step is followed by an implant of an N type dopant such as arsenic to produce a concentration of approximately $1x10^{20}$ atoms/$cm^3$ in the $N^+$ regions 81 in source and drain regions 42 as shown in Fig. 12a. The $N^+$ implant is required to insure good ohmic contact between these regions and later metallization layers (not shown) as described by Grove, Physics and Technology of Semiconductor Devices, John Wiley & Sons, (1967) at page 243, which is incorporated herein by reference. Of importance, sidewall spacers 71 at the edges of gate 23 shield from the $N^+$ implants the portions of the $N^-$ region which underlies the sidewall spacers.

This shielding provides the lateral separation between the $N^+$ regions 81 and the $N^-$ regions 42, as shown in Fig. 12a. The lateral separation is approximately the thickness of the sidewall spacer.

The structure 74 shown in Fig. 12a is then annealed at a temperature of approximately 900°C in order to diffuse the $N^+$ source and drain regions 81 to a depth of approximately 2000Å and thus form structure 80 shown in Fig. 13a. The anneal step also causes some lateral diffusion of the $N^+$ regions 81 under the sidewall spacers 71 approximately equal to 90-100% of the vertical junction depth.

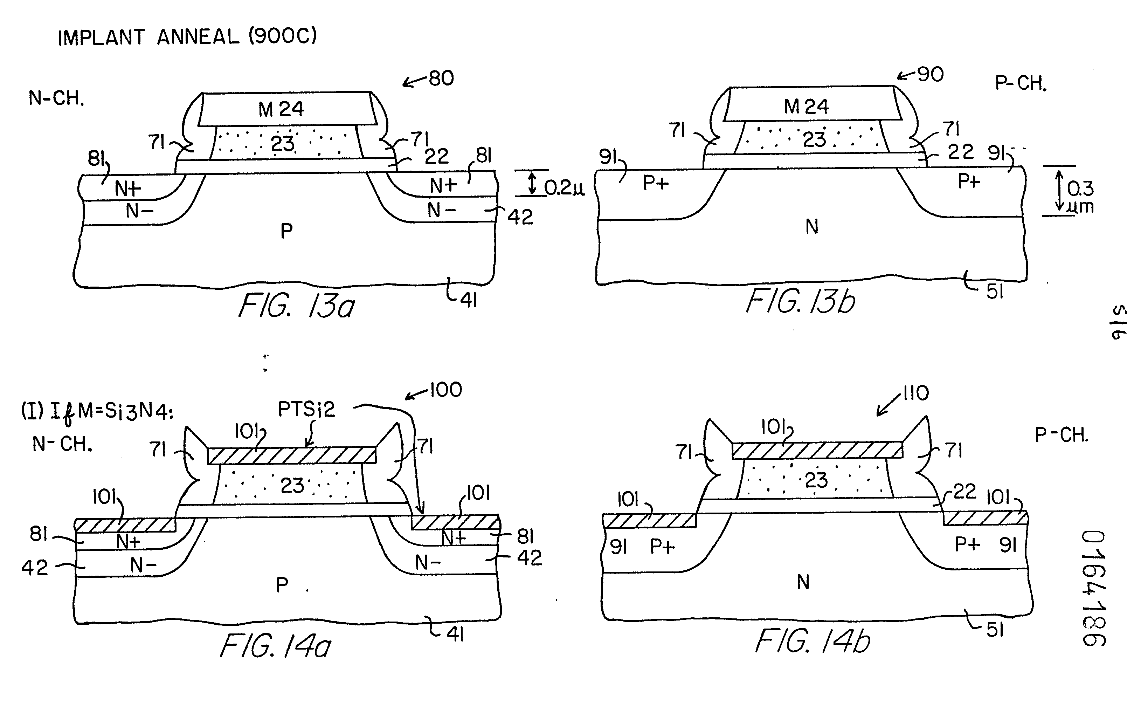

For the formation of P channel devices (i.e. where the underlying substrate region 51 is silicon doped with N type impurities), the vertical etching step is followed by an implant of a P type dopant, such as $BF_2$, to produce a concentration of approximately $5\times10^{19}$ atoms/cm$^3$ in source and drain regions 91 as shown in Fig. 12b. The P type implantation is followed by an implant anneal at a temperature of approximately 900°C in order to form the $P^+$ regions as shown in Fig. 13b. After annealing, the $P^+$ source and drain regions 91 have a thickness of approximately 3,000Å.

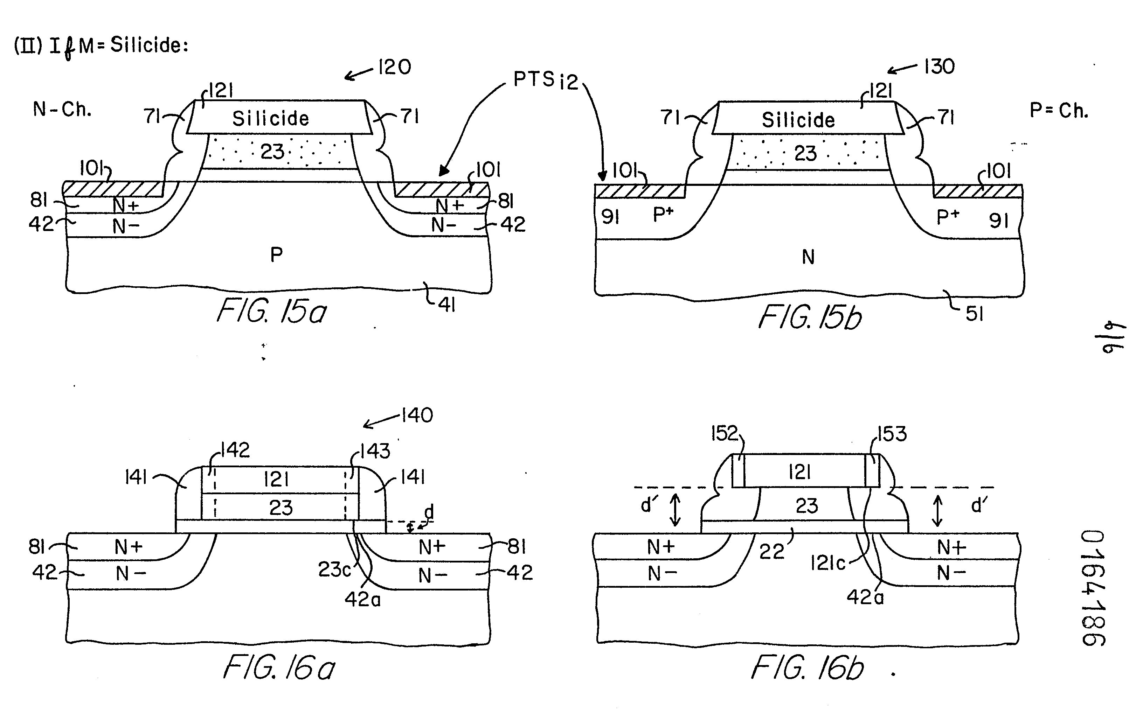

The process steps to complete the formation of the P channel and N channel transistors, now depend on the composition of the second layer of the dual stack. For example, if the second layer 24 is silicon nitride $Si_3N_4$, second layer 24 is removed using well known techniques (such as etching with hot phosphoric acid $H_3PO_4$) and a noble metal such as platinum or a refractory metal such as titanium is deposited, which is then sintered to react with the top portion of the polycrystalline silicon layer23, and with the top portion of $N^+$ and $P^+$ source and drain regions 81 and 91, respectively, to form layer 101 of platinum silicide, PtSi. The unreacted platinum is removed using well known techniques (such as etching with aqua regia) to form the P channel and N channel transistors 100 and 110 respectively, as shown in Fig. 14a and 14b.

If the second layer 24 is silicide, second layer 24 is not removed and platinum is deposited on semiconductor structures 80 and 90, shown in Figs. 13a and 13b, and sintered to react with the top portions of $N^+$ and $P^+$ regions 81 and 91, respectively in order to form platinum silicide layer 101 of transistors 120 and 130 as shown in Figs. 15a and 15b, respectively.

Transistors formed by the above process, using overhang induced sidewall spacers as exemplified in Figs. 14a, 14b, 15a, and 15b, have several advantages over transistors formed by prior art methods.

First, the width, W, of the oxide spacer 71 (as measured near the bottom of spacer 71 as shown in Fig. 11) is principally controlled using the method of the present invention by controlling the degree of undercutting, which depends on the differential etch rates for second layer 24 and underlying doped polycrystalline silicon layer 23, the etch time, and the over etch time, and the thickness of the conformal oxide layer. The width of the oxide spacer formed by prior art methods depends on the geometric factors described in Sidewall Spacer Technology above, including the aspect ratio of the pattern step and the angle that the edge of the pattern step makes with the vertical, as well as the thickness of the CVD layer and over-etch time.

Second, the width, W, of the oxide spacer (as measured near the bottom of the spacer 71) is less sensitive to over etch time of the RIE and to the thickness of the CVD layer 61 than prior art methods as exemplified in Sidewall Spacer Technology, above, due to the protective overhang of second layer 24 as shown in Fig. 11.

Third, Miller capacitance is reduced in transistors having sidewall spacers formed according to this invention. This is illustrated in Figs. 16a and 16b. Fig. 16a shows an N channel transistor 140 formed using prior art sidewall spacers. The Miller capacitance between the right end 143 of the dual stack gate comprising layer 121 and doped polycrystalline layer 23 and the $N^-$ region 42 beneath end 143 is inversely proportional to the distance d between the bottom surface 23c of right end 143 and the surface 42a of $N^-$ region 42. A parallel statement is true for left end 142. On the other hand, when sidewall spacers 71 are formed in accordance with the present invention, the Miller capacitance between the right end 153 of layer 121 and the $N^-$ region 42 beneath end 153 is inversely proportional to the distance d' between the bottom surface 121c of layer 121 and the surface 42a of $N^-$ region 42. A parallel statement is true for left end 152 of layer 121. Since d' is greater than d by construction, Miller capacitance is reduced as compared with the Miller capacitance provided by prior art structures.

The embodiments of my invention described above are meant to be exemplary and not limiting. Many substitutions and modifications may be made without departing from the spirit and scope of the invention.

0164186

- 16 -

<u>CLAIMS</u>

1. A method of forming an insulation sidewall in a semiconductor structure comprising a first layer of polycrystalline silicon which is overlain by a second layer of material which etches more slowly than the polycrystalline silicon for a selected etchant, the method comprising:

etching a portion of the second layer and a portion of the first layer so that the remaining portion of the second layer overhangs the remaining portion of the first layer,

conformally depositing an insulation layer on the structure resulting from etching the portion of the second layer and the portion of the first layer, and then

vertically etching the structure resulting from conformally depositing the insulation layer to form the insulation sidewall to fill the region beneath the remaining portion of the second layer which overhangs the remaining portion of the first layer.

2. A method of forming a semiconductor device having insulation sidewall spacers, the method comprising the following steps:

forming an oxide layer on a silicon substrate doped with selected dopants in selected regions;

forming on the oxide layer a first layer of polycrystalline silicon;

forming a second layer of material on the first layer which second layer has the property that it is etched more slowly than the first layer by a selected etchant;

forming and patterning a layer of photoresist on the second layer;

etching the structure resulting from the above steps to expose selected portions of the oxide layer with an etchant that etches the second layer more slowly than the first layer so that the remaining portions of the second layer overhang the remaining portions of the first layer;

implanting ions of a selected conductivity type into selected ones of the exposed selected portions of the oxide layer;

conformally depositing an insulation layer on the structure resulting after the implanting; and

vertically etching the structure resulting from the conformally depositing to form the insulation sidewall spacers, which fill the regions beneath the remaining portions of the second layer which overhang the remaining portions of the first layer.

3. A method as claimed in Claim 1 or 2 wherein the insulation layer is of silicon dioxide, silicon nitride, aluminum oxide, or a combination of these materials.

4. A method as claimed in Claim 1, 2 or 3 wherein the second layer is of silicide, a refractory metal, or an insulating material.

5. A method as claimed in Claim 1, 2, 3 or 4 wherein the first layer of polycrystalline silicon is doped with a selected dopant.

6. A semiconductor device comprising a gate stack formed on a substrate having selected doped regions, the gate stack comprising a first layer of polycrystalline silicon and a second layer of a silicide, a refractory metal, or an insulating material, each end of the second layer overhanging each end of the first layer, and a sidewall spacer comprising an electrically insulating material, the sidewall spacer filling the region beneath each end of the second layer so as to reduce the capacitance between the ends of the second layer and selected ones of the selected doped regions.

7. A device as claimed in Claim 6 wherein the selected ones of the selected doped regions are source/drain regions of an MOS transistor.

8. A device as claimed in Claim 6 or 7 wherein the electrically insulating material is silicon dioxide, silicon nitride, aluminum oxide, or a combination of these materials.

9. A device as claimed in Claim 6, 7 or 8 wherein the first layer of polycrystalline silicon is doped with a selected dopant.

0164186

FIG 1

FIG 2

FIG 3

FIG 4a

cvd

Pattern Step

Substrate

FIG 4b

Spacer

Pattern Step

Spacer

FIG5.a

FIG.5b

Fig. 5, Geometric factor $F_g$ (=W/d)as function of R and $\emptyset$,(a), Variation of $F_g$ with R using $\emptyset$ and $O_e$ as parametric variables.
(b), Variation of $F_g$ with $\emptyset$ using R as parametric variable.

FIG.6

SUBSTRATE 15

0164186

FIG.9a

FIG.9b

FIG.7

FIG.8

~2000 Å
to 4000Å

CVD   Si O2

M 24

23a          23          23b          61          22

N- 42                    42 N-

21

*FIG. 10*

60

71                    71

M24

0.3μm          23          w          22

Sidewall CVD
Oxide

N- 42                    42 N-

21

*FIG. 11*

70

75

M 24

71          23          71  22

81                                      81

42                                      42

N-                                      N-

P                                        41

*FIG. 12a*

76

M 24

71          23          71  22

91                                      91

P+                                      P+

N-                                      N-

N                                        51

*FIG. 12b*

IMPLANT ANNEAL (900C)

N-CH.

M 24
23
71     71
22
81    81
N+      N+    0.2μ
N–      N–    42
P
41

← 80

*FIG. 13a*

P-CH.

M 24
71    23    71
91      22 91
P+      P+    0.3 μm
N
51

← 90

*FIG. 13b*

(I) If M=Si3N4:
N-CH.

PTSi2
101    71
71    23    101
101      101
81   N+     N+   81
42   N–     N–   42
P
41

← 100

*FIG. 14a*

P-CH.

101
71      71
101    23    22 101
101      101
91   P+     P+   91
N
51

← 110

*FIG. 14b*

(II) I ≠ M = Silicide:

N-Ch.

← 120

PTSi2

← 130

P = Ch.

121
71    Silicide    71
·23·

101
81    N+    81
42    N−    42

P

FIG. 15a

41

101    121    101
71    Silicide    71
·23·

101
91    P+    P+    91

N

FIG. 15b

51

6/6

0164186

← 140

142    143
141    121    141
23
d

81    N+    N+    81
42    N−    23c    N−    42
42a

FIG. 16a

152    153
121
d′    23    d′
N+    22    N+
N−    121c    N−
42a

FIG. 16b

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | IBM TECHNICAL DISCLOSURE BULLETIN, vol. 21, no. 3, August 1978, New York, USA; V.L. RIDEOUT "Fabricating low resistance interconnection lines and FET gates in a single step", pages 1250-1251 | 1-3,6, 7 | H 01 L 21/28 |
| A | idem | 8,9 | |
| | --- | | |
| Y,D | IEEE TRANSACTIONS ON ELECTRON DEVICES, vol. ED-29, no. 4, April 1982, New York, USA; P.J. TSANG et al. "Fabrication of High-Performance LDDFETs with Oxide Sidewall-Spacer technology", pages 590-596 * Page 590, last paragraph * | 1-3,6, 7 | |
| | --- | | **TECHNICAL FIELDS SEARCHED (Int. Cl.4)** |
| A | SOLID-STATE TECHNOLOGY, vol. 26, no. 4, April 1983, Port Washington, USA; W. BEINVOGL et al. "Reactive Ion Etching of Polysilicon and Tantalum Silicide", pages 125-130 * Figure 6 * | 4 | H 01 L 21/28 H 01 L 21/31 H 01 L 21/82 |

The present search report has been drawn up for all claims

| Place of search | Date of completion of the search | Examiner |
|---|---|---|
| BERLIN | 26-06-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82